# EUROPEAN PATENT APPLICATION

(11) **EP 4 636 052 A1**
(43) Date of publication of application: **22.10.2025**
(21) Application number: 23903478.8
(22) Date of filing: 11.12.2023
(51) Int. Cl.: C09K 3/14, B24B 37/00, C09G 1/02, H01L 21/304

(54) **POLISHING COMPOSITION**

(30) Priority: 14.12.2022 JP 2022199399
(71) Applicant: NITTA DuPont Incorporated, Osaka-shi, Osaka 556-0022 (JP)
(72) Inventor: MATSUDA, Shuhei, Kyotanabe-shi, Kyoto 610-0333 (JP); OGAWA, Rina, Kyotanabe-shi, Kyoto 610-0333 (JP)
(74) Representative: Stolmár & Partner Patentanwälte PartG mbB
(86) International application number: PCT/JP2023/044236
(87) International publication number: WO 2024/128192

(57) **Abstract**

Provided is a polishing composition used for polishing a resin, the polishing composition including: water; alumina abrasive grains; and an anionic surfactant, in which the anionic surfactant has two or more benzene rings.

## Description

### CROSS-REFERENCE TO RELATED APPLICATION

This application claims priority to Japanese Patent Application No. 2022-199399, the disclosure of which is incorporated herein by reference in its entirety.

### FIELD

The present invention relates to a polishing composition used for polishing a resin.

### BACKGROUND

In producing semiconductor devices, chemical mechanical polishing (hereinafter referred to as CMP process) is conventionally carried out. For example, a semiconductor device with multilayer wiring, such as an LSI, includes an interlayer insulating film made of a resin. In producing such a semiconductor device, the CMP process is carried out to flatten the surface of each layer. This improves the performance of the semiconductor device.

In general, a polishing slurry in which abrasive grains are dispersed in water is used in the CMP process. For example, Patent Literature 1 discloses, as a polishing slurry for a resin, a polishing slurry including alumina abrasive grains and alkylbenzenesulfonate salt being an anionic surfactant. According to such a polishing slurry, the alkylbenzenesulfonate salt functions to suppress the alumina abrasive grains from settling. This achieves an even supply of the alumina abrasive grains to a polishing pad, thereby being capable of increasing a polishing speed.

### CITATION LIST

### Patent Literature

Patent Literature 1: WO 2019/176558 A

### SUMMARY

### Technical Problem

With a future development of high integration technology, semiconductor devices having more advanced multilayer wiring are expected to be put into practical use. This requires a further increased polishing speed in the CMP process. For such semiconductor devices, a resin excellent in insulation properties, such as a polyimide resin or an epoxy resin, can be employed. However, these resins are relatively hard and may thus hinder the polishing speed from increasing.

In view of the above circumstances, an object of the present invention is to provide a polishing composition excellent in increasing the polishing speed of a resin.

### Solution to Problem

A polishing composition according to one aspect of the present invention is used for polishing a resin, the polishing composition including: water; alumina abrasive grains; and an anionic surfactant, in which the anionic surfactant has two or more benzene rings.

In the polishing composition according to the one aspect of the present invention, the anionic surfactant has three or more benzene rings.

In the polishing composition according to the one aspect of the present invention, a content of the anionic surfactant is 0.2 mass % or more based on a total mass of the polishing composition, and preferably, a ratio of a mass of the anionic surfactant to a mass of the alumina abrasive grains is 1:0.1 or more.

The polishing composition according to the one aspect of the present invention has a pH of 2 to 8.

### DESCRIPTION OF EMBODIMENTS

Hereinafter, a polishing composition according to an embodiment of the present invention will be described.

The polishing composition is used for polishing a resin, and includes water, alumina abrasive grains, and an anionic surfactant. The polishing composition can include a pH adjuster and a defoaming agent. The polishing composition can be a polishing slurry obtained by dispersing alumina abrasive grains in water.

The alumina abrasive grains can be particles made of α-alumina. The alumina abrasive grains can be particles made of, e.g., γ-alumina, δ-alumina, θ-alumina, η-alumina, κ-alumina, or χ-alumina. The alumina abrasive grains can be made of only one kind of these alumina particles, or can be made of two or more kinds of them.

The alumina abrasive grains each have an median diameter of 0.05 to 1 µm. The median diameter is preferably 0.1 to 0.5 µm. The median diameter can be measured as follows. That is, a volume particle size distribution is determined by the laser diffraction/scattering method using a laser diffraction/scattering particle size distribution analyzer LA-920 (HORIBA, Ltd.). The particle size in which the cumulative volume frequency of the obtained volume particle size distribution is 50% is defined as the median diameter of the alumina abrasive grains.

The content of the alumina abrasive grains is preferably 0.3 mass % or more, more preferably 0.5 mass % or more, further preferably 1.0 mass % or more, based on the total mass of the polishing composition. The content of the alumina abrasive grains is preferably 10 mass % or less, more preferably 5.0 mass % or less, further preferably 3.0 mass % or less.

The anionic surfactant has a hydrophobic group having two or more benzene rings, and a sulfate ester as a hydrophilic group.

The hydrophobic group having the two or more benzene rings can have a structure in which two benzene rings are connected via one carbon, as in diphenylmethane; can have a structure in which two benzene rings are directly bonded by a single bond, as in biphenyl; can have a structure in which two benzene rings share a single carbon-carbon bond, as in naphthalene or anthracene; or can have a structure in which two benzene rings are connected via an ether bond (including thioether), as in diphenyl ether.

The hydrophilic group can be a sulfonic acid group, a carboxyl group, or a phosphate ester as well as a sulfate ester. In terms of increasing the polishing speed, the hydrophilic group is preferably a sulfate ester or a sulfonic acid group.

The anionic surfactant can have a structure in which the hydrophobic group and the hydrophilic group are connected via a hydrocarbon group. The hydrocarbon group can have a structure composed of a saturated carbon chain; can have a structure composed of a saturated carbon chain to which an aryl group such as a phenyl group is bonded; can have a structure composed of an unsaturated carbon chain; or can have a structure composed of an unsaturated carbon chain to which an aryl group such as a phenyl group is bonded. For example, the anionic surfactant can have the hydrophobic group bonded to the carbon at one end of an alkylene group as the hydrocarbon group, and the hydrophilic group bonded to the carbon at the other end of the alkylene group.

More specifically, the anionic surfactant can have a structure represented by a chemical formula (1) below. In the chemical formula (1), I represents the degree of substitution into the styryl group in the phenyl group. I is 1 or more, more preferably 2 or more. In other words, the hydrophobic group in the chemical formula (1) has two or more benzene rings, preferably has three or more benzene rings. The hydrophobic group in the chemical formula (1) has six or less benzene rings, preferably four or less benzene rings. In the formula, m represents the degree of polymerization of propylene oxide (PO) in the alkylene group. It is preferable that m be 2 or more. It is also preferable that m be 10 or less. In the formula, n represents the degree of polymerization of ethylene oxide (EO) in the alkyl group. In the formula, n is preferably 5 or more, more preferably 10 or more, further preferably 20 or more. Also, n is preferably 40 or less, more preferably 30 or less. In the alkylene group, a chain consisting solely of PO and a chain consisting solely of EO can be connected, or PO and EO can be connected randomly. Examples of the anionic surfactant having the structure of the chemical formula (1) include polyoxyalkylene polystyrylphenyl ether sulfate salt and polyoxyalkylene polystyrylphenyl ether phosphate salt.

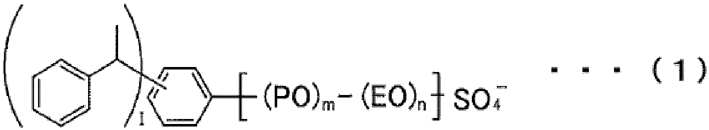

Also suitable as the anionic surfactant is the one having a hydrophobic group composed of diphenyl ether and an sulfonic acid group as a hydrophilic group. Examples of such an anionic surfactant include alkyl diphenyl ether disulfonate salt.

Also suitable as the anionic surfactant is the one having a hydrophobic group composed of naphthalene and a sulfonic acid group as a hydrophilic group. Examples of such an anionic surfactant include naphthalene sulfonate salt, naphthalene disulfonate salt, naphthalene trisulfonate salt, and butyl naphthalene sulfonate salt. The anionic surfactant can also be a salt of a naphthalene sulfonate formalin condensate such as polynaphthyl methanesulfonate salt. Among these, an alkylnaphthalene sulfonate salt such as butylnaphthalene sulfonate salt is preferable.

The anionic surfactant can have the hydrophobic group bonded to the vinyl carbon on an end side of a styrene group as the hydrocarbon group, and the hydrophilic group bonded to the benzene ring of the styrene group. Examples of such an anionic surfactant include 4-4'-bis(2-sulfonatostyryl)biphenyl disodium.

The anionic surfactant can be an alkali metal salt such as sodium or potassium, an ammonium salt with ammonia ionically bonded to the hydrophilic group, or an amine salt with an organic amine ionically bonded to the hydrophilic group. An alkali metal salt is preferable in terms of increasing the polishing speed.

The content of the anionic surfactant is preferably 0.1 mass % or more, more preferably 0.2 mass % or more based on the total mass of the polishing composition. This configuration can sufficiently increase the polishing speed. The content of the anionic surfactant is preferably 1.0 mass % or less. This configuration can suppress foaming at the time of polishing.

The ratio of the mass of the anionic surfactant to the mass of the alumina abrasive grains (i.e., mass of the alumina abrasive grains : mass of the anionic surfactant) is preferably 1:0.1 or more, more preferably 1:0.2 or more, further preferably 1:0.3 or more.

The polishing composition can include the pH adjuster to achieve a pH of 2 to 8. Preferable as the pH adjuster is an inorganic acid such as nitric acid, sulfuric acid, boric acid, carbonic acid, or phosphoric acid; or an inorganic alkaline compound such as sodium hydroxide, potassium hydroxide, sodium carbonate, potassium carbonate, sodium bicarbonate, or potassium bicarbonate. In terms of adjusting a pH to 2 to 8, also preferable as the pH adjuster is, for example, a carboxylic acid such as formic acid, acetic acid, oxalic acid, citric acid, malonic acid, tartaric acid, maleic acid, or malic acid; an amino acid such as glycine or arginine; or an amine compound such as ammonia, primary amine, secondary amine, tertiary amine, quaternary ammonium, or a hydroxide thereof, or a heterocyclic amine.

The polishing composition can be suitably used for polishing a polishing object composed of a polyimide resin, a polybenzoxazole resin, an epoxy resin, or a benzocyclobutene resin. More specifically, the polishing composition can be suitably used for polishing a resin layer made of any of the above resins, such as an interlayer insulating film of a semiconductor device. The polyimide resin is preferably an aromatic polyimide resin having a benzene ring. The epoxy resin preferably has a benzene ring as in a copolymer of a bisphenol compound and epichlorohydrin. This configuration can improve interaction with the hydrophobic group of the anionic surfactant, and can consequently increase affinity between the polishing object and the alumina abrasive grains. The resin forming the polishing object is not limited to those above. For example, the polishing composition, which is more excellent in increasing the polishing speed than the conventional polishing compositions, can be used for polishing a polishing object made of a resin with a higher hardness than that of the above resins. The resin can have a similar hardness to that of the above, or can have a relatively low hardness.

According to the polishing composition, it appears that the hydrophilic group of the anionic surfactant acts to adsorb to the alumina abrasive grains, and that the hydrophobic group of the anionic surfactant and the resin forming the polishing object interact to attract each other. This configuration appears to improve affinity between the alumina abrasive grains and the resin forming the polishing object, thereby increasing the polishing speed. In terms of enhancing the interaction between the hydrophobic group and the resin of the polishing object, it is preferable that the hydrophobic group have three or more benzene rings, and that the resin have an aromatic ring such as a benzene ring.

The polishing composition with a pH of 2 to 8 allows the anionic surfactant (in particular the anionic surfactant represented with the chemical formula (1) above) to easily adsorb to the alumina abrasive grains exhibiting positive zeta potential. These appear to increase the polishing speed. In such a view, the pH of the polishing composition is preferably 3 to 7.

The embodiments have been exemplified hereinbefore, but the polishing composition according to the present invention is not limited to the configurations of the abovementioned embodiments. Further, the polishing composition according to the present invention is not limited to the abovementioned operational effects, either. Various modifications can be made to the polishing composition according to the present invention without departing from the gist of the present invention.

For example, the polishing composition of the present invention can include, as other additives, oxidizing agents such as hydrogen peroxide, complexing agents such as glycine, or defoaming agents such as silicone emulsion. The polishing composition can also include, for example, preservatives or fungicides.

The above embodiment has been exemplified by taking, for example, the case where the polishing composition preferably has a pH of 2 to 8, but besides, the polishing composition with the pH of 5 or more and 11 or less, or the pH of 8 or more and 11 or less can still sufficiently increase the polishing speed.

The polishing composition can also be suitably used for polishing the polishing object not limited to the object forming a semiconductor device but, for example, a printed board, a module board, or a package board, which includes a resin.

The matters disclosed herein include the following:
(1) A polishing composition used for polishing a resin, the polishing composition including: water; alumina abrasive grains; and an anionic surfactant, in which the anionic surfactant has two or more benzene rings.
(2) The polishing composition according to (1) above, in which the anionic surfactant has three or more benzene rings.
(3) The polishing composition according to (1) or (2) above, in which a content of the anionic surfactant is 0.2 mass % or more based on a total mass of the polishing composition.
(4) The polishing composition according to any of (1) to (3) above, in which a ratio of a mass of the anionic surfactant to a mass of the alumina abrasive grains is 1:0.1 or more.
(5) The polishing composition according to any of (1) to (4) above, having a pH of 2 to 8.

### EXAMPLES

Hereinafter, a further description will be given on the present invention by way of Examples, but the present invention is not limited to these Examples.

### [Evaluation 1 of number of benzene rings in anionic surfactant]

The polishing speed was evaluated for each of polishing slurries respectively with compositions shown in Table 1 (the remainder thereof being ultrapure water) under the following conditions:

### (Polishing conditions)

Polishing apparatus: SH24 (SpeedFam)
Polishing pad: IC1000 (manufactured by Nitta DuPont), polishing pad with a polishing surface made of a resin foam (urethane resin foam)
Polishing load: 3 psi
Table rotation speed: 90 rpm
Head rotation speed: 89 rpm
Polishing time: 1 min
Slurry flow velocity: 150 mL/min
Polishing object: Wafer with a polyimide resin film (PI2727 manufactured by Hitachi Chemical Company, Ltd.)

**Table 1**

| Table 1: Evaluation 1 of number of benzene rings | | | | | | | | | | | | | | |
|---|---|---|---|---|---|---|---|---|---|---|---|---|---|---|
| Component (mass %) | No. of benzene rings in surfactant | Ex. 1 | Ex. 2 | Ex. 3 | C. Ex. 1 | C. Ex. 2 | C. Ex. 3 | C. Ex. 4 | C. Ex. 5 | C. Ex. 6 | C. Ex. 7 | C. Ex. 8 | C. Ex. 9 | C. Ex. 10 |
| Sodium polyoxyalkylene polystyrylphenyl ether sulfate | 3-4 | 0.5 | | | | | | | | | | | | |
| Sodium alkvl diohenyl ether disulfonate | 2 | | 0.5 | | | | | | | | | | | |
| Sodium alkyl naphthalene sulfonate | 2 | | | 0.5 | | | | | | | | | | |
| 5-sulfosalicvlic acid / dihydrate | 1 | | | | 0.5 | | | | | | | | | |
| Ammonium benzoate | 1 | | | | | 0.5 | | | | | | | | |
| Benzenesulfonic acid | 1 | | | | | | 0.5 | | | | | | | |
| Sodium alkyl sulfate | 0 | | | | | | | 0.5 | | | | | | |
| Potassium oolvoxvethylene alkyl ether phosohate | 0 | | | | | | | | 0.5 | | | | | |
| Polvoxvethylene paracumyl phenyl ether | 1 | | | | | | | | | 0.5 | | | | |
| Polvoxvethylene polystyrylohenyl ether | 3-4 | | | | | | | | | | 0.5 | | | |
| Polvoxvethylene cumvl phenyl ether | 1 | | | | | | | | | | | 0.5 | | |
| Polyoxyethylene naphthyl ether | 2 | | | | | | | | | | | | 0.5 | |
| Alumina abrasive grains (median diameter: 0.2 *µ* m) | | 2.0 | 2.0 | 2.0 | 2.0 | 2.0 | 2.0 | 2.0 | 2.0 | 2.0 | 2.0 | 2.0 | 2.0 | 2.0 |
| Complexing agent (glycine) | | 0.5 | 0.5 | 0.5 | 0.5 | 0.5 | 0.5 | 0.5 | 0.5 | 0.5 | 0.5 | 0.5 | 0.5 | 0.5 |
| Defoaming agent (silicone-based) | | 0.1 | 0.1 | 0.1 | 0.1 | 0.1 | 0.1 | 0.1 | 0.1 | 0.1 | 0.1 | 0.1 | 0.1 | 0.1 |
| pH (pH adjuster: Nitric acid) | | 3 | 3 | 3 | 3 | 3 | 3 | 3 | 3 | 3 | 3 | 3 | 3 | 3 |
| | | | | | | | | | | | | | | |
| Evaluation result: Polishing speed (Å /min) | | 11491 | 6851 | 6538 | 736 | 1323 | 4276 | 1794 | 2325 | 2473 | 3519 | 3194 | 2691 | 1338 |

The evaluation results in Table 1 show that the polishing speed tends to increase as the number of benzene rings of the anionic surfactant increases. Sodium polyoxyalkylene polystyrylphenyl ether sulfate in Table 1 was analyzed by LC/MS, and by ¹H-NMR and ¹³C-NMR in the following conditions, and was found that I = 2.7, m = 2.4, and n = 26 in the above chemical formula (1).

### (Analysis conditions for LC/MS)

LC equipment: ACQUITY UPLC manufactured by Waters
MS equipment: SYNAPT G2-S manufactured by Waters
Column: Unison UK-C8 (inner diameter of 2 mm, length of 50 mm) manufactured by Imtakt
Column temperature: 40 °C
Mobile phase A: 10 mM ammonium formate aqueous solution
Mobile phase B: Acetonitrile
%B: 25 (0 min) → 100 (10-15 mins)
Flow velocity: 0.4 mL/min
Detectors: PDA, MS
Detection wavelength: 254 nm
Ionization method and polarity: ESI method, negative
Measuring mass range: m/z50 to 2000
Sample injection amount: 0.2 µL (MS) or 0.5 µL (MS/MS)
Sample preparation: 20 mg sample / 10 mL methanol

### (Analysis conditions for NMR)

Equipment: AVANCE NEO 600 manufactured by Bruker Japan
Measurement solvent: Deuterated methanol, approx. 100 mg/mL sample
Internal reference material: TMS (0 ppm)

### [Evaluation 1 of content of anionic surfactant]

As shown in Table 2, sodium polyoxyalkylene polystyrylphenyl ether sulfate, which showed good results in the evaluation in Table 1, was used to evaluate how its content relative to the total mass of the polishing composition would affect the polishing speed. The polishing conditions were as in the above conditions.

**Table 2**

| Table 2: Evaluation 1 of content of surfactant | | | | | | | |
|---|---|---|---|---|---|---|---|
| Component (mass %) | Ex. 4 | Ex. 5 | Ex. 6 | Ex. 7 | Ex. 8 | Ex. 9 | C. Ex. 11 |
| Sodium polyoxyalkylene polystyrylphenyl ether sulfate salt | 0.1 | 0.2 | 0.3 | 0.5 | 1.0 | 2.0 | |
| Alumina abrasive grains (median diameter: 0.2 *µ*m) | 2.0 | 2.0 | 2.0 | 2.0 | 2.0 | 2.0 | 2.0 |
| Complexing agent (glycine) | 0.5 | 0.5 | 0.5 | 0.5 | 0.5 | 0.5 | 0.5 |
| Defoaming agent (silicone-based) | 0.1 | 0.1 | 0.1 | 0.1 | 0.1 | 0.1 | 0.1 |
| pH (pH adjuster: Nitric acid) | 3 | 3 | 3 | 3 | 3 | 3 | 3 |
| Alumina abrasive grains: Surfactant | 1 : 0.05 | 1 : 0.1 | 1 : 0.15 | 1 : 0.25 | 1 : 0.5 | 1 : 1 | - |
| | | | | | | | |
| Evaluation result: Polishing speed (Å/min) | 2983 | 9866 | 12798 | 13545 | 16573 | 16531 | 1727 |

As shown in Table 2, the polishing speed tended to increase as the content of sodium polyoxyalkylene polystyrylphenyl ether sulfate increased.

### [Evaluation 2 of content of anionic surfactant]

As shown in Table 3, it was evaluated how a ratio of the mass of sodium polyoxyalkylene polystyrylphenyl ether sulfate to the mass of alumina abrasive grains would affect the polishing speed. The polishing conditions were as in the above conditions.

**Table 3**

| Table 3: Evaluation 2 of content of surfactant | | | | | |
|---|---|---|---|---|---|
| Component (mass %) | Ex. 10 | Ex. 11 | Ex. 7 | Ex. 12 | Ex. 13 |
| Sodium polyoxyalkylene polystyrylphenyl ether sulfate salt | 0.5 | 0.5 | 0.5 | 0.5 | 0.5 |
| Alumina abrasive grains (median diameter: 0.2 *µ* m) | 0.5 | 1.0 | 2.0 | 4.0 | 10.0 |
| Complexing agent (glycine) | 0.5 | 0.5 | 0.5 | 0.5 | 0.5 |
| Defoaming agent (silicone-based) | 0.1 | 0.1 | 0.1 | 0.1 | 0.1 |
| pH (pH adiuster: Nitric acid) | 3 | 3 | 3 | 3 | 3 |
| Alumina abrasive grains: Surfactant | 1 : 1 | 1 : 0.5 | 1 : 0.25 | 1 : 0.125 | 1 : 0.05 |
| | | | | | |
| Evaluation result: Polishing speed (Å/min) | 8536 | 11685 | 13545 | 16582 | 7426 |

It was found from the evaluation results in Table 3 that a preferable mass ratio of sodium polyoxyalkylene polystyrylphenyl ether sulfate to the alumina abrasive grains was 1:0.1 or more.

### [Evaluation of effect of complexing agent and defoaming agent]

As shown in Table 4, it was evaluated how the use of sodium polyoxyalkylene polystyrylphenyl ether sulfate as the anionic surfactant would affect the complexing agent and the defoaming agent. The polishing conditions were as in the above conditions.

**Table 4**

| Table 4: Evaluation of effect of complexing agent and defoaming agent | | | |
|---|---|---|---|
| Component (mass %) | Ex. 8 | Ex. 14 | Ex. 15 |
| Sodium polyoxyalkylene polystyrylphenyl ether sulfate salt | 0.5 | 0.5 | 0.5 |
| Alumina abrasive grains (median diameter: 0.2 *µ* m) | 2.0 | 2.0 | 2.0 |
| Complexing agent (glycine) | 0.5 | | |
| Defoaming agent (silicone-based) | 0.1 | 0.1 | |
| pH (pH adiuster: Nitric acid) | 3 | 3 | 3 |
| | | | |
| Evaluation result: Polishing speed (Å/min) | 13545 | 14581 | 13885 |

As shown in Table 4, no inhibitory action was found by the complexing agent and the defoaming agent.

### [Evaluation of pH]

As shown in Table 5, it was evaluated how pH would affect the polishing speed when sodium polyoxyalkylene polystyryl phenyl ether sulfate was used as the anionic surfactant. In this evaluation, used as a polishing pad was a polishing pad (SUBA (registered trademark) manufactured by Nitta DuPont) made of a polyester nonwoven cloth as a base material impregnated with a thermosetting resin (thermosetting polyurethane resin).

**Table 5**

| Table 5: Evaluation of pH | | | | | | | |
|---|---|---|---|---|---|---|---|
| Component (mass %) | Ex. 16 | Ex. 17 | Ex. 18 | Ex. 19 | C. Ex. 12 | C. Ex. 13 | C. Ex. 14 |
| Sodium polyoxyalkylene polystyrylphenyl ether sulfate salt | 0.5 | 0.5 | 0.5 | 0.5 | - | - | - |
| Alumina abrasive grains (median diameter: 0.2 *µ* m) | 2.0 | 2.0 | 2.0 | 2.0 | 2.0 | 2.0 | 2.0 |
| Complexing agent (glycine) | 0.5 | - | - | - | - | - | - |
| Defoaming agent (silicone-based) | 0.1 | - | - | - | - | - | - |
| pH (pH adjuster: Nitric acid or potassium hydroxide) | 3 | 3 | 7 | 11 | 3 | 7 | 11 |
| | | | | | | | |
| Evaluation result: Polishing speed (Å/min) | 24179 | 26701 | 23459 | 11668 | 3592 | 3083 | 3346 |

As shown in Table 5, it can be understood that each of those polishing slurries with a pH of 2 to 8 is even more excellent in increasing the polishing speed.

### [Evaluation of degree of polymerization of anionic surfactant]

As shown in Table 6, it was evaluated how the degree of polymerization of the anionic surfactant having two or more benzene rings and having an alkylene group would affect the polishing speed. The polishing condition was the condition in which a polishing pad with the polishing surface made of the resin foam (urethane resin foam) was used.

**Table 6**

| Table 6: Evaluation 1 of degree of polymerization | | | |
|---|---|---|---|
| Component (mass %) | No. of benzene rings in surfactant | Ex. 20 | Ex. 21 |
| Sodium polyoxyalkylene polystyrylphenyl ether sulfate salt (used in Tables 1-5) | 3-4 | 0.5 | |
| Sodium polyoxyalkylene polystyrylphenyl ether sulfate salt (with smaller degree of polymerization of EO and PO than in Ex. 20) | 3-4 | | 0.5 |
| Alumina abrasive grains (median diameter: 0.2 *µ* m) | | 2.0 | 2.0 |
| Complexing agent (glycine) | | 0.5 | 0.5 |
| Defoaming agent (silicone-based) | | 0.1 | 0.1 |
| pH (pH adjuster: Nitric acid) | | 3 | 3 |
| | | | |
| Evaluation result: Polishing speed (Å/min) | | 11197 | 10464 |

As shown in Table 6, it was found that the degree of polymerization of the alkylene group of the anionic surfactant affected the polishing speed.

### [Evaluation of abrasive grains]

As shown in Table 7, the type of abrasive grains was evaluated when sodium polyoxyalkylene polystyrylphenyl ether sulfate was used as the anionic surfactant. The polishing condition was the condition in which a polishing pad with the polishing surface made of the resin foam (urethane resin foam) was used.

**Table 7**

| Table 7: Evaluation of type of abrasive grains | | | | | | | |
|---|---|---|---|---|---|---|---|
| Component (mass %) | Ex. 7 | C. Ex. 15 | C. Ex. 16 | C. Ex. 17 | C. Ex. 18 | C. Ex. 19 | C. Ex. 20 |
| Sodium polyoxyalkylene polystyrylphenyl ether sulfate salt | 0.5 | 0.1 | 2.0 | 0.1 | 2.0 | 0.1 | 2.0 |
| Alumina abrasive grains (median diameter: 0.2 *µ*m) | 2.0 | | | | | | |
| Anion-modified colloidal silica (secondary particle size: 70 nm) | | 8.0 | 8.0 | | | | |
| Colloidal silica (secondary particle size: 70 nm) | | | | 8.0 | 8.0 | | |
| Cation-modified colloidal silica (secondary particle size: 70 nm) | | | | | | 8.0 | 8.0 |
| Complexing agent (glycine) | 0.5 | 0.5 | 0.5 | 0.5 | 0.5 | 0.5 | 0.5 |
| Defoaming agent (silicone-based) | 0.1 | 0.1 | 0.1 | 0.1 | 0.1 | 0.1 | 0.1 |
| pH (pH adjuster: Nitric acid) | 3 | 3 | 3 | 3 | 3 | 3 | 3 |
| | | | | | | | |
| Evaluation result: Polishing speed (Å/min) | 13545 | 379 | 21 | 961 | 2 | 133 | 40 |

It was found from the evaluation results in Tables 1 to 7 that the alumina abrasive grains and sodium polyoxyalkylene polystyrylphenyl ether sulfate produced a synergistic effect. As shown in Table 7, in contrast, those abrasive grains other than the alumina abrasive grains were not found to produce a synergistic effect with sodium polyoxyalkylene polystyrylphenyl ether sulfate.

### [Evaluation 2 of number of benzene rings in anionic surfactant]

The polishing speed was evaluated for each of polishing slurries respectively with compositions shown in Table 8 (the remainder thereof being ultrapure water). This evaluation was carried out under the same polishing conditions as in Examples and Comparative Examples shown in Table 1, except that SUBA (registered trademark) manufactured by Nitta DuPont was used as the polishing pad.

**Table 8**

| Table 8: Evaluation 2 of number of benzene rings | | | | | |
|---|---|---|---|---|---|
| Component (mass %) | No. of benzene rings in surfactant | Ex. 22 | Ex. 23 | C. Ex. 21 | C. Ex. 22 |
| Sodium polyoxyalkylene polystyrylphenyl ether sulfate | 3-4 | 0.5 | | | |
| 4-4' -bis(2-sulfonatostyryl)biphenyl disodium | 4 | | 0.5 | | |
| Triethanolamine dodecvlbenzene sulfonate salt | 1 | | | 0.5 | |
| Alumina abrasive grains (median diameter: 0.2 *µ* m) | | 2.0 | 2.0 | 2.0 | 2.0 |
| Complexing agent (glycine) | | 0.15 | 0.15 | 0.15 | 0.15 |
| Defoaming agent (silicone-based) | | 0.1 | 0.1 | 0.1 | 0.1 |
| pH (pH adjuster: KOH) | | 9.5 | 9.5 | 9.5 | 9.5 |
| | | | | | |
| Evaluation result: Polishing speed (Å/min) | | 12615 | 9081 | 6728 | 5161 |

It is found also from the evaluation results in Table 8 that the polishing speed tends to increase as the number of benzene rings of the anionic surfactant increases.

## Claims

1. A polishing composition used for polishing a resin, the polishing composition comprising:
water; alumina abrasive grains; and an anionic surfactant, wherein
the anionic surfactant has two or more benzene rings.

2. The polishing composition according to claim 1, wherein the anionic surfactant has three or more benzene rings.

3. The polishing composition according to claim 1 or 2, wherein a content of the anionic surfactant is 0.2 mass % or more based on a total mass of the polishing composition.

4. The polishing composition according to claim 3, wherein a ratio of a mass of the anionic surfactant to a mass of the alumina abrasive grains is 1:0.1 or more.

5. The polishing composition according to claim 1 or 2, having a pH of 2 to 8.
